# EUROPEAN PATENT SPECIFICATION

(11) **EP 0 459 631 B1**
(45) Date of publication and mention of the grant of the patent: **12.08.1998**
(21) Application number: 91303877.4
(22) Date of filing: 29.04.1991
(51) Int. Cl.: H03H 3/02, H03H 9/19

(54) **AT-cut crystal oscillating element and method of making the same**
In AT-Richtung geschnittenes Kristalloszillatorelement und sein Herstellungsverfahren
Elément oscillant coupé selon une direction AT et sa méthode de fabrication

(30) Priority: 27.04.1990 JP 114686/90; 19.09.1990 JP 249649/90; 19.09.1990 JP 249650/90; 19.09.1990 JP 249651/90; 19.09.1990 JP 249652/90; 21.09.1990 JP 252260/90; 21.09.1990 JP 252261/90
(43) Date of publication of application: 04.12.1991
(73) Proprietor: SEIKO EPSON CORPORATION, Shinjuku-ku Tokyo (JP)
(72) Inventor: Nakamura, Hideaki, Suwa-shi, Nagano-ken (JP); Karaki, Eiji, Suwa-shi, Nagano-ken (JP)
(74) Representative: Sturt, Clifford Mark

(56) References cited:
- DE-A- 2 362 515
- DE-B- 1 247 415
- GB-A- 2 021 311
- PATENT ABSTRACTS OF JAPAN vol. 13, no. 463 (E-833)(3811) 19 October 1989 & JP- A-1 179 513 ( KINSEKI LTD ) 17 July 1989
- PATENT ABSTRACTS OF JAPAN vol. 5, no. 86 (E-60)(758) 5 June 1981 & JP-A-56 034 216 ( SUWA SEIKOSHA ) 6 April 1981
- PATENT ABSTRACTS OF JAPAN vol. 9, no. 43 (E-298)(1766) 22 February 1985 & JP-A- 59 182 615 ( MIYOTA SEIMITSU ) 17 October 1984
- PATENT ABSTRACTS OF JAPAN vol. 6, no. 99 (E-111)(977) 8 June 1982 & JP-A-57 032 115 ( NIPPON DENPA KOGYO ) 20 February 1982

## Description

The present invention relates to a crystal oscillating element for use in an AT-cut crystal oscillator which serves as a reference frequency source for a clock, a computer, and information communication equipment and the like, and also relates to a method of manufacturing the element.

An example of an AT-cut crystal oscillating element manufactured by an etching method disclosed in JP-A-1-179513 is described below.

Furthermore GB-A-2 021 311 discloses a rectangular AT-cut quartz resonator which is cut in the same manner as in the present application with respect to axes X, Y',Z' and which has side surfaces tilted substantially 5 degrees around the X-axis.

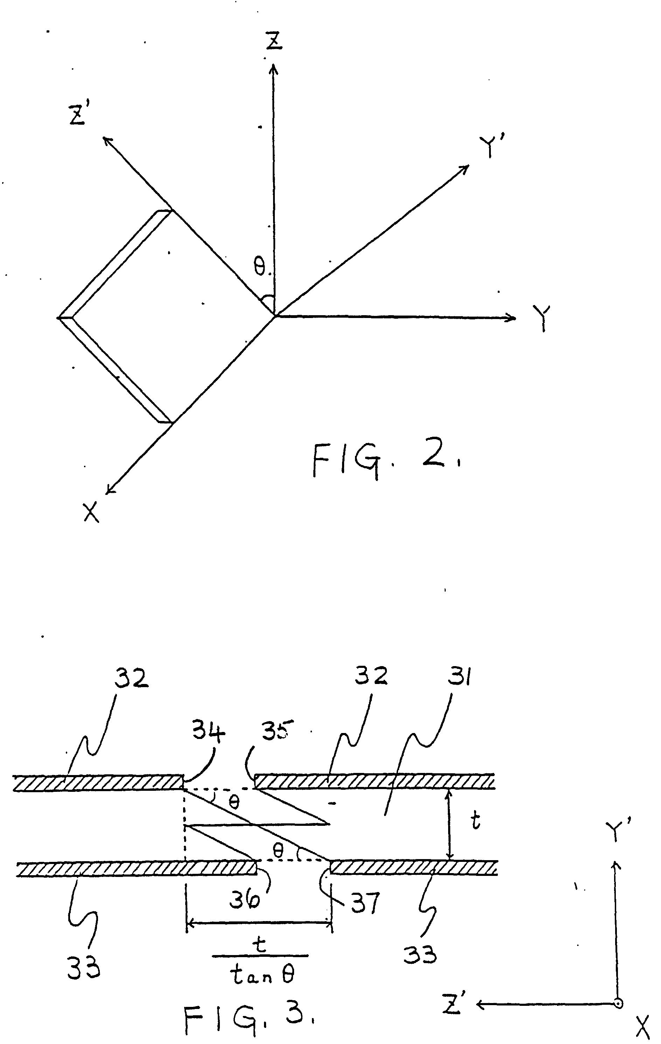

Figure 2 illustrates a method of cutting an AT-cut crystal oscillating element which may be employed on a variety of crystal oscillating elements. Referring to the drawing, X, Y and Z-axes denote the initial axial directions of the element, and they can be obtained by rotating a parallel cut crystal oscillating member by an angle of θ°. Z' and Y'-axes denote axial directions of the new axes.

Figure 3 is a cross-sectional view which illustrates this AT-cut crystal oscillating element which has been subjected to etching. As shown in Figure 3, corrosion resisting films 32, 33 are respectively formed on each of the upper and lower surfaces of a crystal wafer 31 having a thickness of t, the films 32, 33 being provided so as to prevent unnecessary propagation of the etching. An extension of a line connecting an end portion 34 of an upper corrosion resisting film 32 and an end portion 37 of a lower corrosion resisting film 33 is shifted by t/tan θ° with respect to the space between the upper and lower films in the direction of the Z' axis. Another end portion 35 of an upper corrosion resisting film 32, and another end portion 36 of a lower corrosion resisting film 33 are respectively arranged to be at a proper distance from the upper end portion 34 and the lower end portion 37 in order to maintain a width which is necessary to perform etching. According to this example, each of the distances from the upper end portion 34 to the other end portion 35 and that from the lower end portion 36 to the other lower end portion 37 is arranged to be the half of the distance from the upper end portion 34 to the lower end portion 37.

In consequence, the etching propagates from both the upper and lower surfaces in the direction of the Z-axis until the two etching propagations encounter each other at a position at which the thickness t is halved.

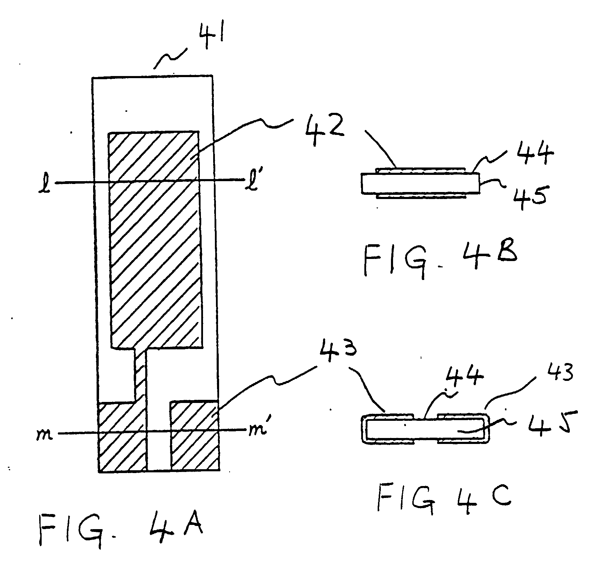

Figures 4(A), 4(B), 4(C) illustrate an AT-cut crystal oscillating element which is known to the Applicants and on which an electrode film has been formed. Figure 4A is a plan view, Figure 4B is a cross sectional view taken along line 1-1' of Figure 4A and Figure 4C is a cross-sectional view taken along line m-m' of Figure 4A. Referring to Figure 4A, reference numeral 41 represents a crystal oscillating element, 42 represents excitation electrodes formed to face each other with the crystal oscillating element 41 therebetween, and 43 represents connection electrodes for establishing a connection with external equipment. As shown in Figures 4(B) and 4(C), the element 41 has main surfaces 44 and side surfaces 45.

As shown in Figures 4B and 4C, moreover, each connection electrode 43 for establishing a connection with external equipment is formed from a main surface 41 to a side surface 45 so that the two sides of the AT-cut crystal oscillating element are electrically connected to each other. However, the excitation electrodes 42 do not extend to the side surfaces 45.

Each electrode is formed in such a way that a metal mask having an aperture in a form approximating to the shape of the electrode is used to hold the crystal oscillating member while metal such as chromium or silver is evaporated thereon.

When voltage is applied to the crystal oscillating element 41 via the connection electrodes 43 for establishing a connection with external equipment, an electric field is produced between the excitation electrodes 42 so that the crystal oscillating element 41 is oscillated. At this time, the excitation electrodes 42 act to confine oscillation energy.

However, the AT-cut crystal oscillating element manufactured by the above-described etching method raises the following problems due to the fact that the side surfaces (the surfaces to be subjected to etching) are disposed diagonally with respect to the surface of the corrosion resisting film and that the same has two steps and sharpened front portions:
(1) Spurious oscillations can undesirably be generated, causing the oscillation characteristics of the element to be deteriorated.
(2) The front portion of the element can easily be broken, and its reliability will diminish in a long period.
(3) When the AT-cut crystal oscillating element is clamped, cracks may be formed in the clamped portion. If this occurs, the clamped portion will easily be broken, and satisfactory oscillations cannot be generated.

Furthermore, when the size of the crystal oscillating element 41 is reduced, the above-described AT-cut crystal oscillating element encounters a problem in that its crystal impedance (to be called a "CI value" hereinafter) becomes excessively large since oscillation energy cannot satisfactorily be confined by the overlap effect of the excitation electrodes 42. What is even worse, the method of forming the electrodes, in which the metal mask is used, raises a problem in that satisfactory adhesion cannot be achieved. As a result, a clear contour cannot be obtained, and a desired positional accuracy cannot be obtained between the crystal oscillating member 41 and the metal mask. Therefore, uniform characteristics cannot be achieved.

According to one aspect of the present invention, there is provided an AT-cut crystal oscillating element produced by forming spaced apart upper and lower corrosion resistant films on its upper and lower surfaces respectively, and etching the element, the upper and lower surfaces being parallel to a cutting axis Z', where the cutting axis Z' is defined relative to the Z-axis of the crystal by rotation around the X-axis by an angle θ and characterised in that:
the films are spaced such that the distance between the spaced apart films on each of the surfaces is at least t/tan θ, where t is the thickness of the element;
the distance along the Z'-axis between diagonally opposing films is at least t/tan θ; and
the oscillating element has at least one end surface approximately perpendicular to the upper and lower surfaces.

Preferably θ° is in the range from +35° to + 40°.

The element may have a mount portion the width of which is different from the width of a main oscillating portion thereof.

The element may be substantially rectangular in widthwise cross-section centrally of the element and has an end surface which is shaped substantially as a parallelogram.

The element may be provided on each of its opposite sides with first and second metal films which only partially overlap one another so that the cross-sectional shape of the element varies.

The element may have at least one reduced thickness portion which meets another portion of the element at a step.

The element may have a main surface on which there is at least one excitation electrode for oscillating the element and at least one connection electrode for establishing a connection with external equipment, a side electrode being formed on at least one side surface of the element.

According to another aspect of the present invention, there is provided a method of making an AT-cut crystal oscillating element comprising; forming spaced apart upper corrosion resistant films on the upper surface of the element and spaced apart lower corrosion resistant films on the lower surface of the element, the upper and lower surfaces being parallel to a cutting axis Z', where the cutting axis Z' is defined relative to the Z-axis of the crystal by rotation around the X-axis by an angle θ, and etching the element, characterised by spacing the films such that:
the distance between the spaced-apart films on each of the surfaces is at least t/tan θ, where t is the thickness of the element; and
the distance along the Z'-axis between diagonally opposing films is at least t/tan θ.

The arrangement may be such that 1 = t/tan θ, where 1 is the distance between adjacent elements produced from a common crystal wafer, and t is the thickness of the element.

A crystal oscillating element according to the present invention may have a reduced size, a low CI value, uniform characteristics and satisfactory reliability.

The method of making the AT-cut crystal oscillating element according to the present invention gives excellent mass production capability and thereby provides a cheap AT-cut crystal oscillating element.

The AT-cut crystal oscillating element may be obtained by cutting an AT-cut crystal oscillating element at a predetermined cutting angle to have a predetermined thickness from a rough crystal, the AT-cut crystal oscillating element comprising: a mount portion the width of which is different from the width of a main oscillating portion.

The AT-cut crystal oscillating element may have a rectangular planar shape, excitation electrodes being provided for both sides thereof. The AT-cut crystal oscillating element may have a cross-section in the widthwise direction of a substantially rectangular shape at the central portion of the excitation electrodes and at least one end of an end surface in the lengthwise direction may be in the form of a parallelogram.

The AT-cut crystal oscillating element may have at least an excitation electrode for oscillating the AT-cut crystal oscillating element and an electrode for establishing a connection with external equipment, these electrodes being on a main surface of the AT-cut crystal oscillating element, the AT-cut crystal oscillating element comprising a side electrode formed on an overall side surface of the AT-cut crystal oscillating element.

In making an AT-cut crystal oscillating element according to the invention, the upper and lower surfaces of an AT-cut crystal wafer may be provided with corrosion resisting films, and the method of manufacture may comprise the following steps. If the thickness of the AT-cut crystal wafer is expressed by t, and if an extension, which establishes a connection between an upper end and a lower end of a corrosion resisting film is substantially in the direction of the Z-axis, and if a lengthwise component, which is parallel to a Z'-axis, of the distance from the upper end to the lower end of the corrosion resisting films is expressed by 1, then 1 is made longer than t/tanθ°, where 1 is a lengthwise component, which is parallel to the Z'-axis, of the distance from an intersection of the Z-axis on the upper surface of the crystal wafer to an intersection on the lower surface of the same, the corrosion resisting films being formed while arranging that the distance between the two tipper ends and that between the two lower ends is 1 or more.

Each corrosion resisting film may be a metal film and the latter may be subjected to etching so as to make it suitable to serve as an electrode film after the AT-cut crystal oscillating element has been subjected to etching.

The invention is illustrated, merely by way of example, in the accompanying drawings, in which:-
Figures 1A-1D are cross-sectional views which illustrate a crystal wafer for use in a first embodiment of an AT-cut crystal oscillating element according to the present invention, Figure 1A illustrating a state in which a crystal wafer has been cut, Figure 1B illustrating the wafer before etching is performed, Figure 1C illustrating a state in which etching is being performed, and Figure 1D illustrating a state in which etching has been performed;
Figure 2 illustrates the relationship between the axes of an AT-cut crystal;
Figure 3 is a cross-sectional view which illustrates a state in which an AT-cut crystal known to the Applicants has been subjected to etching;
Figures 4A-4C illustrate an AT-cut crystal oscillating element known to the Applicants having electrode films formed thereon, Figure 4A being a plan view, Figure 4B being a cross-sectional view taken along line 1-1' of Figure 4A, and Figure 4C being a cross-sectional view taken along line m-m' of Figure 4A;
Figures 5A-5C are cross-sectional views which illustrate a second embodiment of an AT-cut crystal oscillating element according to the present invention, Figure 5A being a cross-sectional view which illustrates a state before a crystal wafer has been subjected to etching, Figure 5B being a cross-sectional view which illustrates a state in which etching is being performed, and Figure 5C being a cross-sectional view which illustrates a state after etching has been performed;
Figures 6A and 6B illustrate a third embodiment of a rectangular AT-cut crystal oscillating element according to the present invention, Figure 6A being a plan view, and Figure 6B being a side elevational view;
Figures 7A and 7B illustrate a fourth embodiument of a rectangular AT-cut crystal oscillating element according to the present invention, Figure 7A being a plan view, and Figure 7B being a side elevational view;
Figures 8 and 9 are plan views which illustrate fifth and sixth embodiments respectively of a rectangular AT-cut crystal oscillating element according to the present invention;
Figures 10A-10C illustrate a seventh embodiment of a rectangular AT-cut crystal oscillating element according to the present invention, Figure 10A being a plan view, Figure 10B illustrating the shape of the upper end surface thereof, and Figure 10C being a cross-sectional view taken along line 1-1' of Figure 10B;
Figures 11A-11C illustrate an eighth embodiment of a rectangular AT-cut crystal oscillating element according to the present invention, Figure 11A being a plan view, Figure 11B illustrating the shape of the upper end surface thereof, and Figure 11C being a side elevational view;
Figure 12 illustrates the shape of the upper end surface in a state where etching is being performed;
Figures 13A-13C illustrate a ninth embodiment of an AT-cut crystal oscillating element according to the present invention, Figure 13A being a plan view, Figure 13B being a vertical cross-sectional view, and Figure 13C being a horizontal cross sectional view which illustrates an excitation electrode portion;
Figures 14A-14C illustrate a tenth embodiment of an AT-cut crystal oscillating element according to the present invention, Figure 14A being a plan view, Figure 14B being a vertical cross-sectional view, and Figure 14C being a horizontal cross-sectional view which illustrates an excitation electrode portion;
Figures 15A-15C illustrate an eleventh embodiment of an AT-cut crystal oscillating element according to the present invention, Figure 15A being a plan view, Figure 15B being a vertical cross-sectional view, and Figure 15C being a horizontal cross-sectional view which illustrates an excitation electrode portion;
Figures 16A-16C illustrate a twelfth embodiment of an AT-cut crystal oscillating element according to the present invention, Figure 16A being a plan view, Figure 16B being a vertical cross-sectional view, and Figure 16C being a horizontal cross-sectional view which illustrates an excitation electrode portion;
Figures 17A and 17B illustrate a thirteenth embodiment of an AT-cut crystal oscillating element according to the present invention, Figure 17A being a plan view, and Figure 17B being a side elevational view;
Figures 18A and 18B illustrate a fourteenth embodiment of an AT-cut crystal oscillating element according to the present invention. Figure 18A being a plan view, and Figure 18B being a cross-sectional view which illustrates the central portion;
Figures 19A to 19C illustrate a fifteenth embodiment of an AT-cut crystal oscillating element according to the present invention, Figure 19A being a plan view, Figure 19B being a cross-sectional view taken along line 1-1', and Figure 19C being a cross-sectional view taken along line m-m';
Figures 20A-20L schematically illustrate an embodiment of a method of making an AT-cut crystal oscillating element according to the present invention;

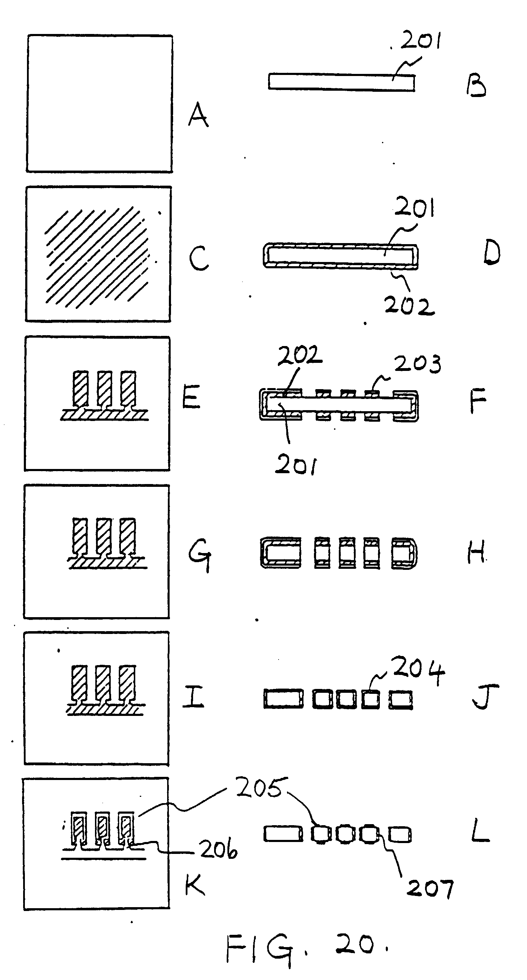

Figures 20A and 20B illustrate a condition in which a crystal wafer has been ground to shape, wherein Figure 20A is a plan view and Figure 20B is a cross-sectional view;
Figures 20C and 20D illustrate a condition in which a metal film is formed, wherein Figure 20C is a plan view and Figure 20D is a cross-sectional view;
Figures 20E and 20F illustrate a condition in which the metal film is shaped, wherein Figure 20E is a plan view and Figure 20F is a cross-sectional view;
Figures 20G and 20H illustrate a condition in which the shape of the crystal oscillating elements is formed, wherein Figure 20G is a plan view and Figure 20H is a cross-sectional view;
Figures 20I and 20J illustrate a condition in which an electrode film is formed, wherein Figure 20I is a plan view and Figure 20J is a cross-sectional view;
Figures 20K and 20L illustrate a condition in which the electrode film is given a predetermined shape, wherein Figure 20K is a plan view and Figure 20L is a cross-sectional view;

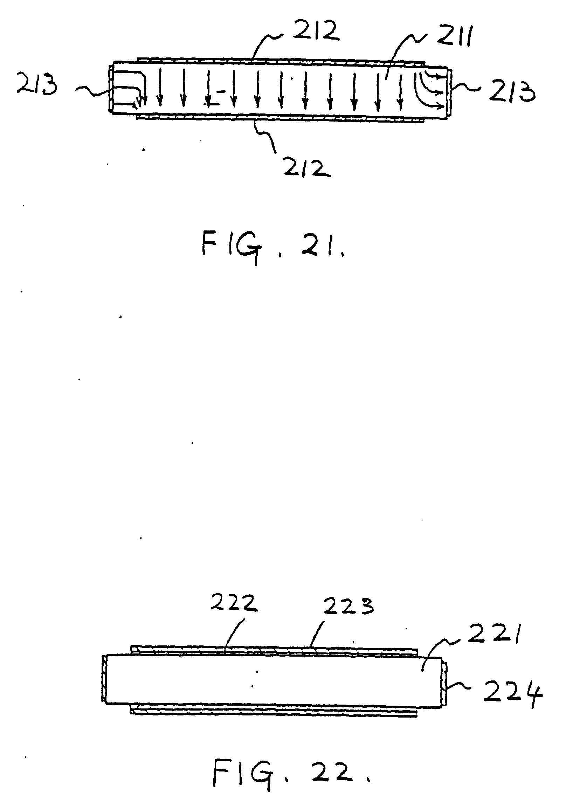

Figure 21 is a cross-sectional view which illustrates an excitation electrode portion of an embodiment of an AT-cut crystal oscillating element according to the present invention;
Figure 22 is a cross-sectional view which illustrates an excitation electrode portion of another embodiment of an AT-cut crystal oscillating element according to the present invention;

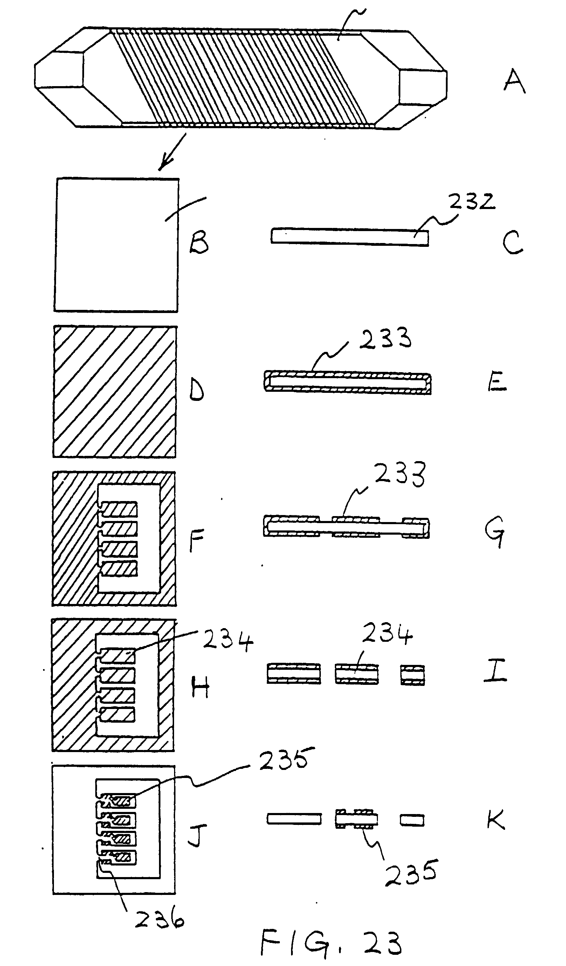

Figures 23A-23K schematically illustrate another embodiment of a method of making an AT-cut crystal oscillating element according to the present invention;
Figure 23A illustrates a process of cutting a rough crystal into crystal wafers;
Figures 23B and 23C illustrate a crystal wafer which has been ground to size, wherein Figure 23B is a plan view and Figure 23C is a cross-sectional view;
Figures 23D and 23E illustrate the formation of a metal film, wherein Figure 23D is a plan view and Figure 23E is a cross-sectional view;
Figures 23F and 23G illustrate the shaping of the metal film, wherein Figure 23F is a plan view and Figure 23G is a cross-sectional view;
Figures 23H and 23I illustrate the formation of the crystal oscillating elements, wherein Figure 23H is a plan view and Figure 23I is a cross-sectional view; and
Figures 23J and 23K illustrate the formation of the electrode films, wherein Figure 23J is a plan view and Figure 23K is a cross-sectional view.

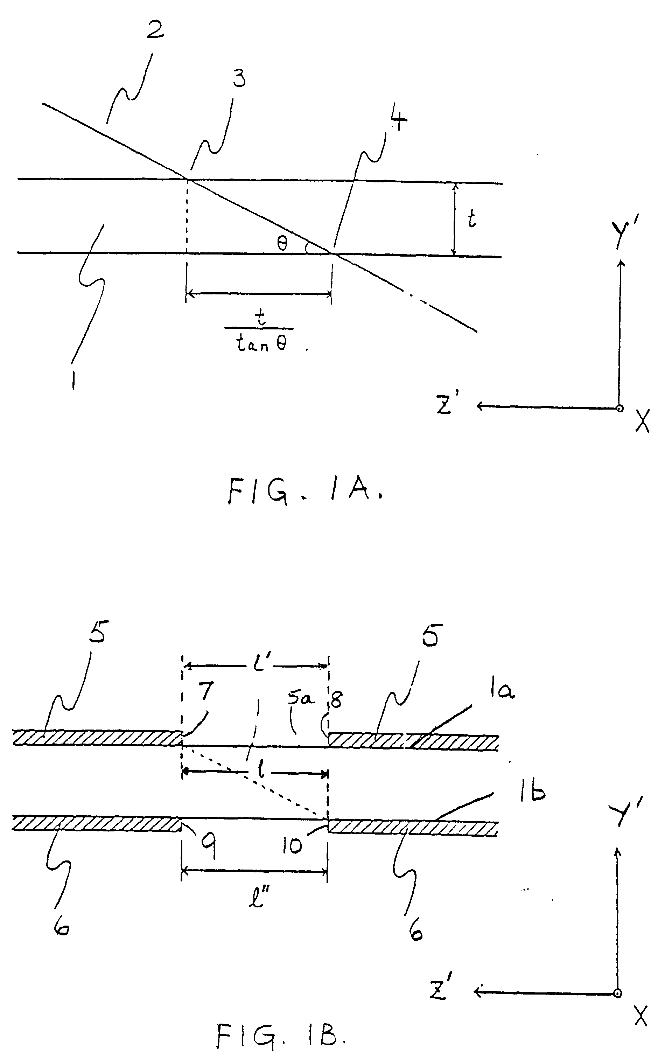

Figure 1A is a cross-sectional view which illustrates a method of etching an AT-cut crystal oscillation element according to the first embodiment of the present invention.

A crystal wafer 1 for use in the AT-cut crystal oscillating element is an AT plate obtained by cutting a quartz crystal by a method which is similar to known technology, the crystal wafer 1 being obtainable by rotating a parallel cut crystal member by an angle of θ° relative to the X-axis. According to this embodiment, θ° is in the range from + 35° to + 40°. The crystal wafer 1 is obtained by cutting a rough crystal, and its contour is shaped before its surface is subjected to polishing. Axes Z' and Y' respectively are the new axial directions which are given to the wafer.

As shown in Figure 1B, the upper and lower surfaces 1a, 1b of the crystal wafer 1 respectively have corrosion resisting films 5 and 6 formed by evaporating, sputtering or plating Cr, Au or the like. The corrosion resisting films 5 and 6 have gaps 5a, 6a therein respectively for use at the time of etching the crystal wafer 1. The gaps 5a, 6a are formed by a photo-etching method by utilizing a photoresist and an etching liquid such as aqua regia. The thickness of the crystal wafer 1 is expressed by t. The direction of an extension, which establishes a connection between an upper end portion 7 and a lower end portion 10 of the corrosion resisting films 5 and 6 adjacent the gaps 5a, 6a, respectively, is arranged to be substantially in the direction of the Z-axis. A lengthwise component, which is parallel to the Z'-axis, of the distance from the upper end portion 7 to the lower end portion 10 is expressed by 1. The arrangement is such that 1 is, as shown in Figure 1A, given the value t/tan θ° which is a lengthwise component, parallel to the Z'-axis, of the distance from an intersection 3 of the Z-axis on the upper surface of the crystal wafer 1 to an intersection 4 on the lower surface of the same. Furthermore, as shown again in Figure 1B, the value 1 is given to the distance from the upper end portion 7 to the upper end portion 8 and that from the lower end portion 9 to the lower end portion 10, i.e. to the distance between adjacent elements produced from a common crystal wafer. According to this embodiment, since the extension which establishes a connection between the upper end portion 7 and the lower end portion 10 overlaps the Z-axis, the upper end portion 7 overlaps the upper intersection 3, while the lower end portion 10 overlaps the lower intersection 4.

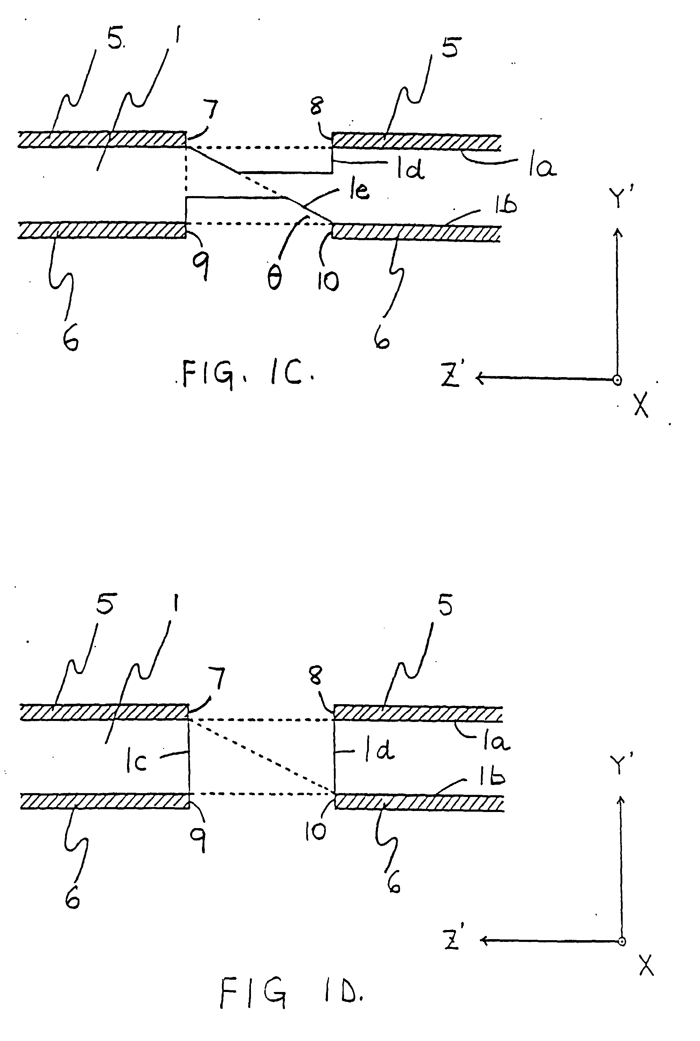

Subsequently, the crystal wafer having the above-described gaps is subjected to etching by an etching liquid such as a liquid mixture of a hydrofluoric acid solution and an ammonium fluoride solution. In consequence, a trapezoid-like cross-sectional shape is formed as shown in Figure 1C whose lower surface 1b is parallel to the main surfaces of the wafer, whose side or end surfaces 1c, 1d are respectively surfaces making an angle, which approximates to an angle of 90°, with respect to the main surfaces of the wafer and which has a further surface 1e which is inclined at an angle of θ°. Then, etching is continued while leaving, to serve as the end surfaces of the oscillating element, the serve as the end surfaces of the oscillating element, the above-described surfaces 1c, 1d which make an angle of about 90° with respect to the main surfaces of the wafer. As a result of the etching operation, a plurality of AT-cut crystal oscillating elements having flat end surfaces 1c, 1d as shown in Figure 1D can be obtained. Each crystal oscillating element thus manufactured has surfaces 1c, 1d which make an angle of about 90° with the main surfaces of the wafer so that the surfaces 1c, 1d can be used as end surfaces of the oscillating element. As described above, the side surfaces are flat surfaces which are substantially perpendicular to the surfaces of the corrosion resisting films 5, 6 and which have no steps. In consequence, an AT-cut crystal oscillating element can be obtained which exhibits advantages in that excellent vibration characteristics can be achieved, satisfactory reliability can be maintained for a long time and significant impact resistance can be displayed.

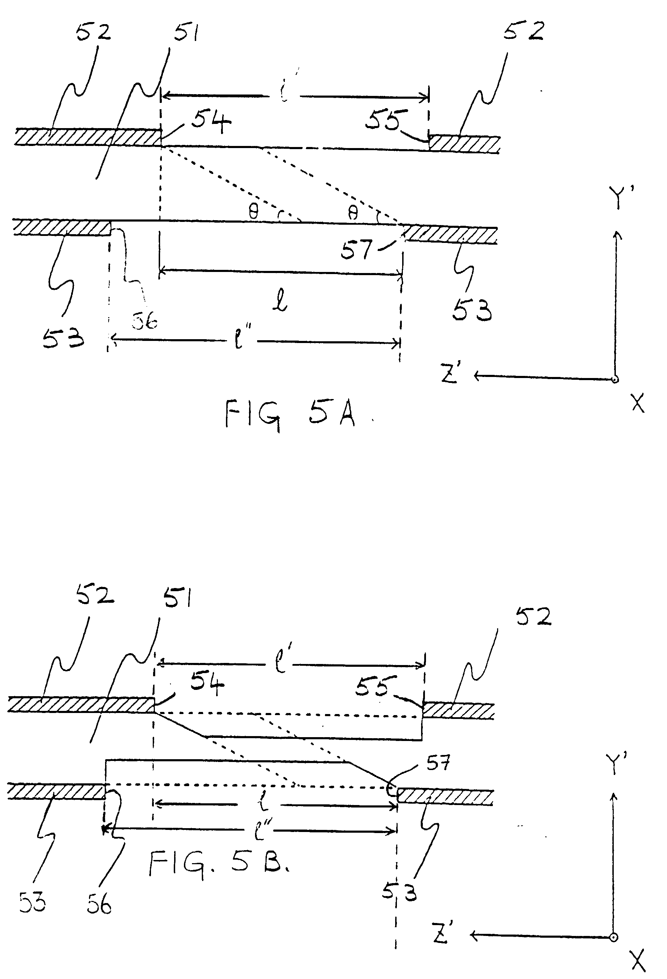

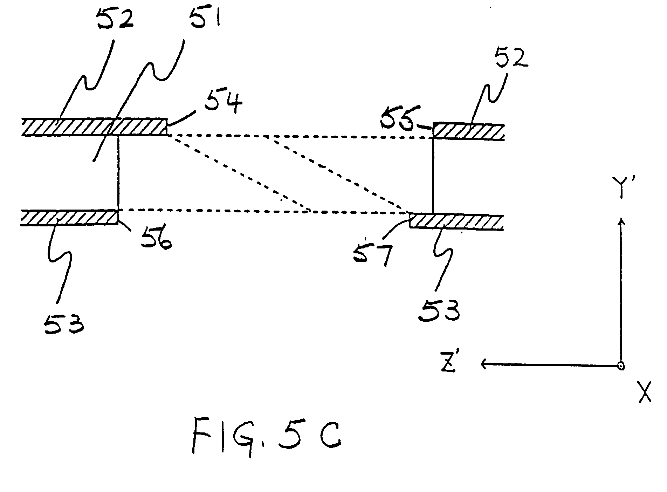

According to this embodiment, the lengthwise component 1, which is parallel to the Z'-axis, of the distance from the upper end portion 7 to the lower end portion 10 is arranged to be t/tan θ°, and the gap from the upper end portion 7 to the upper end portion 8 and that from the lower end portion 9 to the lower end portion 10 are respectively arranged to be 1. Therefore, there is no transverse deviation between the upper end portion 7 and the lower end portion 9 and between the upper end portion 8 and the lower end portion 10. The reason for this lies in the fact that the upper and lower masks must easily be aligned with each other at the time of performing photo-etching. Furthermore, it is necessary for 1 to be t/tan θ° or longer, while the gap between the upper end portions 7 and 8 and that between the lower end portions 9 and 10 must be 1 or longer. It is no longer necessary for the gap between the upper end portions 7 and 8 and the gap between the lower end portions 9 and 10 to be the same. They may be different from each other if they respectively exceed 1. Figures 5A, 5B and 5C are views corresponding to those of Figures 1B, 1C, 1D respectively which show a second embodiment of the present invention which has this feature. The widthwise dimension of the AT-cut crystal oscillating element is determined depending upon the position of an upper end 55 and a lower end 56.

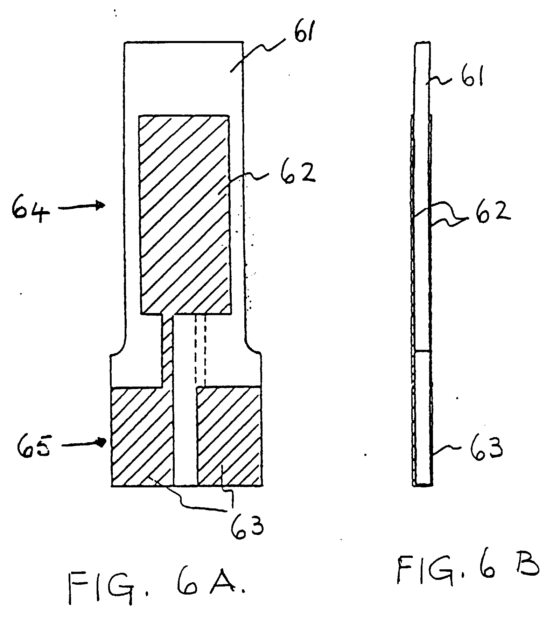

Figure 6 illustrates essential portions of the shape of a third embodiment of a rectangular AT-cut crystal oscillation element according to this embodiment, Figure 6A being a plan view and Figure 6B being a side elevational view. Reference numeral 61 represents a crystal oscillating element which has been cut at a predetermined angle to have a predetermined thickness. Reference numeral 62 represents metal-film excitation electrodes formed on the oppositely disposed main surfaces of the crystal oscillating element 61. Reference numeral 63 represents connection electrodes for establishing a connection with external equipment. When voltage is applied from outside via the connection electrode 63 for establishing a connection with external equipment, an electric field is created between the two excitation electrodes 62 formed on the main surfaces of the crystal oscillating element 61. In consequence, the crystal oscillating element 61 is oscillated.

The width of the oscillating element at the excitation electrodes 62 (to be called a "main oscillating portion" 64 hereinafter) is the same as that of a conventional rectangular AT-cut crystal oscillating reed. However, the width of the portion 65 of the element 61 (to be called a "mount portion" hereinafter) which is provided with the connection electrodes 63 for establishing a connection with external equipment is arranged to be larger than that of the main oscillating portion 65.

In the rectangular AT-cut crystal oscillating reed shown in Figures 6A and 6B, oscillations generated in the main oscillating portion are not transmitted to the mount portion since their characteristic frequency changes at the boundary of the mount portion in which the widthwise dimension is changed. In particular, the significant effect of preventing planar slide oscillations, which are the sub-oscillations, can be obtained. In consequence, the oscillation energy can be satisfactorily confined further in the main oscillating portion so that the CI value is improved.

Furthermore, if a rectangular AT-cut crystal oscillating element having a different frequency is desired, a mount portion having the same width can be used since it is only necessary for the widthwise dimension of the main oscillating portion to be changed. Therefore, widthwise directional positioning can always be completed in the widthwise direction of the mount portion.

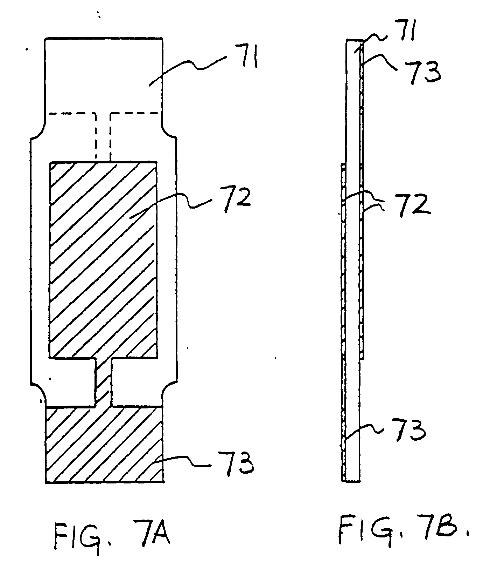

Figures 7A and 7B illustrate a fourth embodiment of a rectangular AT-cut crystal oscillation element according to the present invention, Figure 7A being a plan view and Figure 7B being a side elevational view. Referring to Figures 7A and 7B, reference numeral 71 represents a crystal oscillating element, 72 represents excitation electrodes and 73 represents connection electrodes for establishing a connection with external equipment.

The rectangular AT-cut crystal oscillating element shown in Figures 6A and 6B is so arranged that only its lower portion is used to establish the connection with external equipment and to perform a supporting function. However, the rectangular AT-cut crystal oscillating reed shown in Figures 7A and 7B is so arranged that two electrodes 73 having individual polarities are provided for the upper portion and the lower portion of the element respectively so as to establish the above-described connection and to perform a supporting function.

The widthwise dimension of each of the upper and lower mount portions is arranged to be smaller than that of the main oscillating portion. A similar effect to that of the element of Figures 6A and 6B can be obtained from the above-described shape.

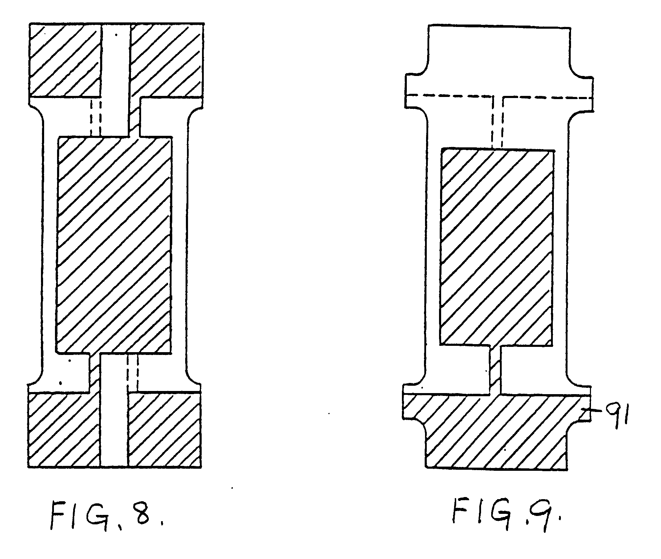

Figure 8 is a plan view which illustrates a fifth embodiment of a rectangular AT-cut crystal oscillating element according to the present invention. The rectangular AT-cut crystal oscillating element shown in Figure 8 has the advantage that it can be used regardless of its positional attitude in terms of the top and bottom thereof.

Figure 9 is a plan view which illustrates a sixth embodiment of a rectangular AT-cut crystal oscillating element according to the present invention. The rectangular AT-cut crystal oscillating element shown in Figure 9 has the advantage that a projection 91 formed in the mount portion effectively positions the lateral direction. Furthermore, it acts as a guide when a terminal for establishing a connection with external equipment having a slit is provided.

A significant effect can be obtained when the AT-cut crystal oscillating element according to the present invention is manufactured by an etching process. That is, the AT-cut crystal oscillating element can be manufactured by an etching process while arranging that the end surfaces of the longer side or the shorter side are the flat surfaces which are substantially perpendicular to the surfaces (main surfaces) of the above-described corrosion resisting films, the end surfaces having no steps. When the AT-cut crystal oscillating element is manufactured by the conventional machining process, a complicated manufacturing process is necessary. However, it is simply necessary to prepare a photomask for projecting the shape of the corrosion resisting film when the AT-cut crystal oscillating element is manufactured by the etching process. In consequence, the AT-cut crystal oscillating element according to the present invention can be manufactured while preventing an increase in the number of manufacturing steps by comparison with those required when a crystal oscillating element, which has a main oscillating portion and a mount portion having the same widthwise dimension, is manufactured by an etching process.

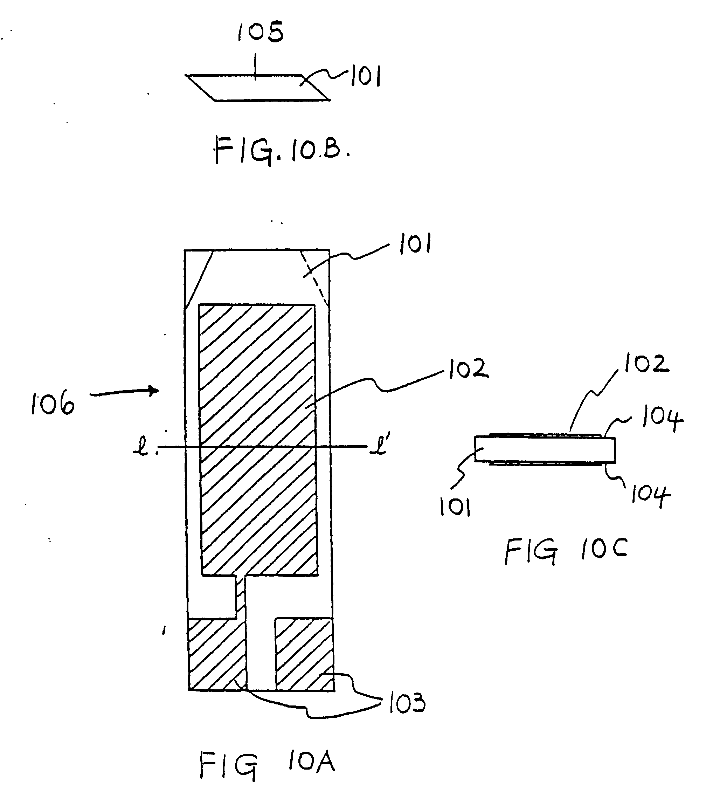

Figures 10A-10C illustrate a seventh embodiment of a rectangular AT-cut crystal oscillating element according to the present invention, Figure 10A being a plan view, Figure 10B being a top view and Figure 10C being a cross sectional view taken along line 1-1' of Figure 10A. Refering to Figures 10A-10C, reference numeral 101 represents a crystal oscillating element, 102 represents excitation electrodes, 103 represents connection electrodes for establishing a connection with external equipment and 104 represents the main surfaces of the element.

As shown in Figures 10A and 10B, the upper end surface 105 of the crystal oscillating element 101 is in the form of a parallelogram. The partial cross-sectional shape of the excitation electrodes 102 is in the shape of a rectangle and the main oscillating portion 106 also has a rectangular shape in widthwise cross-section.

In this case, the oscillation frequency in the excitation electrodes 102 and the initial oscillation energy are the same as those of the rectangular AT-cut crystal oscillating element shown in Figures 4A-4C. However, the oscillations cannot easily be transmitted to the upper end of the crystal oscillating element 101 because the number of portions in which the thickness is changed increases in the crystal oscillating element 101 in the direction toward the end portion. Since the AT-cut crystal oscillator generates oscillations in a thickness-shear manner, the characteristic frequency is determined in accordance with the thickness of the crystal oscillating element 101. Therefore, the oscillations cannot easily be transmitted to a portion having a different thickness. This means that energy undesirably discharged from the end surfaces can be reduced, and that a satisfactorily large energy can be confined in the excitation electrodes. In consequence, a crystal oscillator displaying a low CI value is obtained.

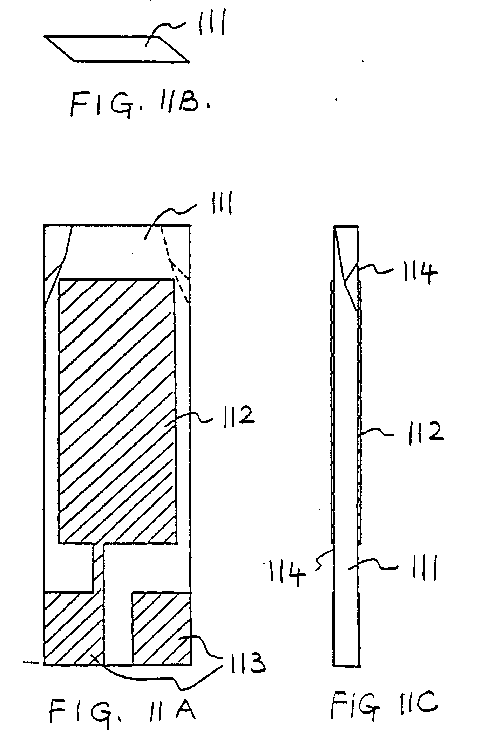

Figures 11A-11C illustrate the shape of an eighth embodiment of a rectangular AT-cut crystal oscillating element, Figure 11A being a plan view, Figure 11B being a top view and Figure 11C being a side elevational view. Referring to Figures 11A-11C, reference numeral 111 represents a crystal oscillating member, 112 represents excitation electrodes, 113 represents connection electrodes for establishing a connection with external equipment, and 114 represents a main surface.

The shape shown in Figures 11A-11C can be formed in such a way that corrosion resisting films each of which has substantially the same shape as the planar shape of the crystal oscillating element 111 may be formed on the two sides. Furthermore, the contour of the crystal oscillating element 111 is subjected to etching in which etching liquid such as hydrofluoric acid is used. Since the element 111 has a crystal structure, specific crystal faces are allowed to appear when crystal is subjected to etching.

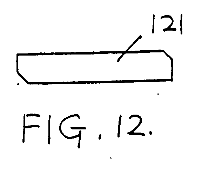

Figure 12 illustrates the upper end surface 121 of a crystal oscillating element when etching is being performed. As shown in Figure 11B, the time for which etching is performed is set so as to make the end surface 121 have the form of a parallelogram.

An effect similar to that obtainable from the crystal oscillator shown in Figures 10A-10C can be obtained from the crystal oscillator shown in Figures 11A-11C. When the AT-cut oscillating element shown in Figures 10A-10C is manufactured by machining, a rectangular oscillating element is cut and the front portion thereof must then be ground. However, an AT-cut crystal oscillating element capable of revealing a similar effect and shown in Figures 11A-11C can be manufactured by etching without increasing the number of manufacturing steps. A plane which is substantially perpendicular to the main surface 114 is employed to serve as an end surface.

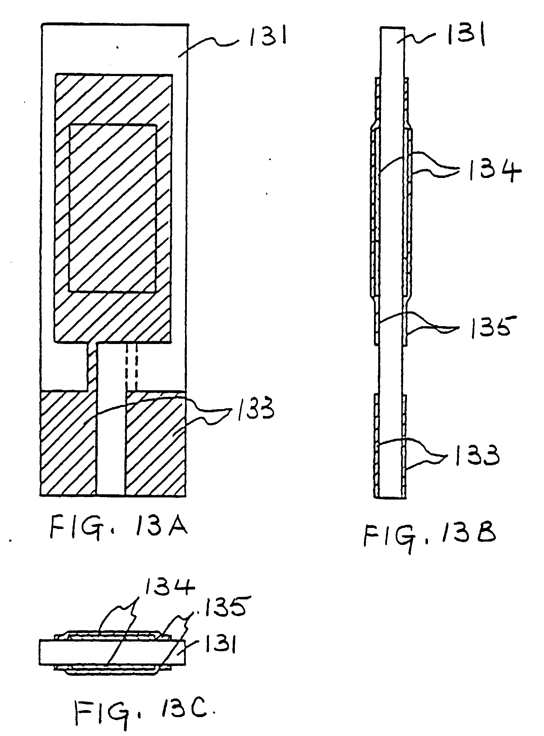

Figures 13A-13C illustrate a ninth embodiment of an AT-cut crystal oscillating element according to the present invention, Figure 13A being a plan view, Figure 13B being a vertical cross-sectional view, and Figure 13C being a horizontal cross-sectional view which illustrates an excitation electrode portion. Referring to Figures 13A-13C, reference numeral 131 represents a crystal oscillating element or at a predetermined angle to have a predetermined thickness. Reference numeral 134 represents first metal films formed on the central portions of each of the opposite main surfaces of the crystal oscillating element 131. Reference numeral 135 represents second metal films a portion of each of which is mounted on the respective first metal film 131, a second metal film 135 being formed on each of the opposite main surfaces of the crystal oscillating element 131. Reference numeral 133 represents connection electrodes for establishing a connection with external equipment.

The first metal films 131 are formed by evaporating or sputtering chromium and subsequently evaporating or sputtering gold. The second metal films 135 and the connection electrodes 133 are formed by evaporating or sputtering chromium and subsequently evaporating or sputtering silver.

When voltage is applied to the AT-cut crystal oscillating element shown in Figures 13A-13C via the connection electrodes 133 for establishing a connection with external equipment, the first and second metal films 134 and 135 act as excitation electrodes so that an electric field acts between the two sides of the crystal oscillating element 131. Although the crystal oscillating element 131 oscillates at its characteristic frequency at this time, the characteristic frequency of the portion in which the first and second metal films 134 and 135 are stacked one on top of the other, that of the portion in which only the second metal films 135 are present, and that of a peripheral portion in which no metal film is present respectively are different from one another. Therefore, it is difficult for oscillations generated in a central portion in which the first and second metal films 134 and 135 are stacked on top of one another to be transmitted to the portion in which only the second metal films 135 are present. It is further difficult for the oscillations of the central portion to be transmitted to the portion in which no metal film is present. That is, the oscillation energy generated in the central portion can efficiently be confined thereto. In consequence, a crystal oscillating element having a low CI value is obtained.

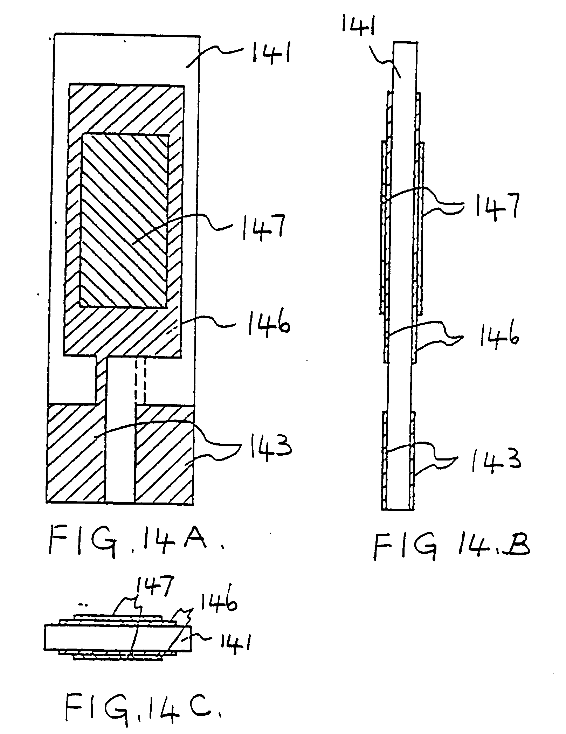

Figure 14 illustrates a tenth embodiment of an AT-cut crystal oscillating element according to the present invention, Figure 14A being a plan view, Figure 14B being a vertical cross-sectional view, and Figure 14C being a horizontal cross-sectional view of an excitation electrode portion. Referring to Figures 14A-14C, a crystal oscillating element 141 has connection electrodes 143 for establishing a connection with external equipment, the latter being arranged similarly to those of the crystal oscillating element shown in Figures 13A-13C. Reference numeral 146 represents first metal films, while reference numeral 147 represents second metal films mounted on the first metal films 146 and formed at substantially central portions of the first metal films 146. The first and second metal films 146 and 147 are arranged to serve as excitation electrodes in association with each other.

The first metal films 146 and the connection electrodes 143 for establishing a connection with external equipment are formed by evaporating chromium and silver. Subsequently, the second metal films 147 are formed by evaporating chromium and silver.

Similarly to the AT-cut crystal oscillating element shown in Figures 13A-13C, the oscillation energy generated in the portion in which the above-described metal films are stacked on one another is confined to the central portion. In consequence, a crystal oscillator displaying a low CI value is obtained.

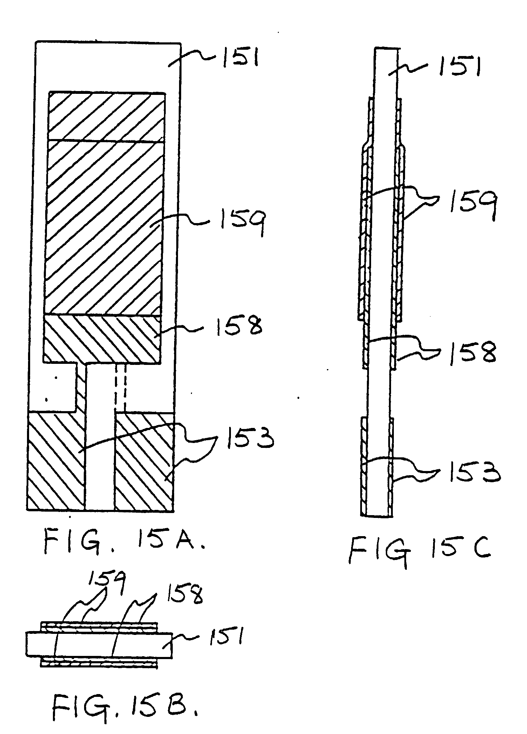

Figures 15A-15C illustrate an eleventh embodiment of an AT-cut crystal oscillating element according to the present invention, Figure 15A being a plan view, Figure 15B being a vertical cross-sectional view and Figure 15C being a horizontal cross sectional view of an excitation electrode portion. Referring to Figures 15A-15C, a crystal oscillating element 151 and a connection electrode 153 for establishing a connection with external equipment are arranged similarly to those of the crystal oscillating reed shown in Figures 13A-13C. Reference numeral 158 represents a first metal film, while reference numeral 159 represents a second metal film a portion of which is mounted on the first metal film 158. The first and second metal films 158 and 159 are arranged to serve as an excitation electrode in association with each other.

Also the AT-cut crystal oscillating element shown in Figures 15A-15C is able to display an effect similar to that obtainable from the AT-cut crystal oscillating element shown in Figures 14A-14C.

Although the description above concerns an AT-cut crystal oscillator having a rectangular shape, the present invention is not limited to the shape of the crystal oscillating element and that of the electrodes thereon. Therefore, the present invention can be applied to a disc like AT-cut crystal oscillator.

A significant effect can be obtained from the present invention when a crystal oscillating element is manufactured by an etching process comprising successive etching steps. Thus, an etching process cannot be combined with a conventional convex process or a bevel process to which the end portion of a crystal oscillating element is subjected in order to improve the characteristics such as the CI value. However, the CI value can be improved without the convex process or the bevel process in the case of the AT-cut crystal oscillating element according to the present invention. Therefore, a significant effect can be obtained.

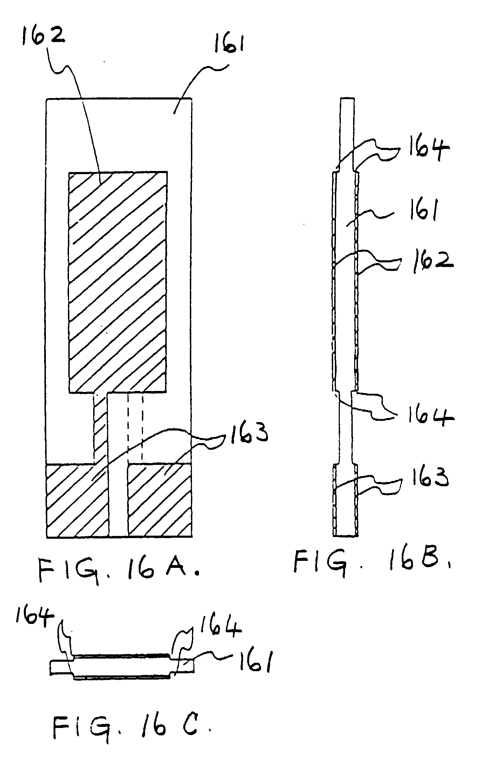

Figures 16A-16C illustrate a twelfth embodiment of an AT-cut crystal oscillating element according to the present invention, Figure 16A being a plan view, Figure 16B being a vertical cross-sectional view and Figure 16C being a horizontal cross-sectional view of an excitation electrode portion.

Referring to Figures 16A-16C, reference numeral 161 represents a crystal oscillating element, 162 represents excitation electrodes and 163 represents connection electrodes for establishing a connection with external equipment, the above-described elements 161, 162 and 163 being arranged similarly to those shown in Figures 4A, 4C. Reference numeral 164 represents steps in the thickness direction of the crystal oscillating element 161. The crystal oscillating element 161 has a large thickness in the portions thereof provided with the excitation electrodes 162 and with the connection electrodes 163 for establishing a connection with external equipment, while the element has a reduced thickness in other portions thereof.

The excitation electrodes 162 have the effect of confining energy. The AT-cut crystal oscillator shown in Figures 16A-16C has the additional effect of confining energy by means of the steps 164. Since the thickness of the crystal oscillating element 161 between the excitation electrodes 162 and the thickness of the element in the other peripheral portions are different from each other, the characteristic frequency becomes different in the above-described portions. In consequence, oscillations generated in the portion between the excitation electrodes 162 cannot be transmitted to the peripheral portions.

The reason why the portion of the element provided with the mount electrodes 163 has the same thickness as that of the portion provided with the excitation electrodes 162 is to facilitate manufacture. Therefore, it is not provided just for the purpose of obtaining the above-described effect of confining energy.

The crystal oscillating element 161 can be manufactured by a method similar to that for manufacturing the AT-cut crystal oscillating element shown in Figure 4. As described above, it can be manufactured by cutting a rough crystal at a cutting angle which is known as an "AT-cut". Subsequently, it is ground to a thickness which is determined by the desired oscillation frequency. Then, flat surfaces are formed thereon, and a metal film is adhered to the electcrode. The above-described process is the same as the process for manufacturing a conventional AT-cut crystal oscillating element. Subsequently, while using the electrode film as a corrosion resisting film, the crystal oscillating element 161 is subjected to etching so that the steps 164 are formed. The etching may be either wet etching, in which hydrofluoric acid or the like is used, or dry etching.

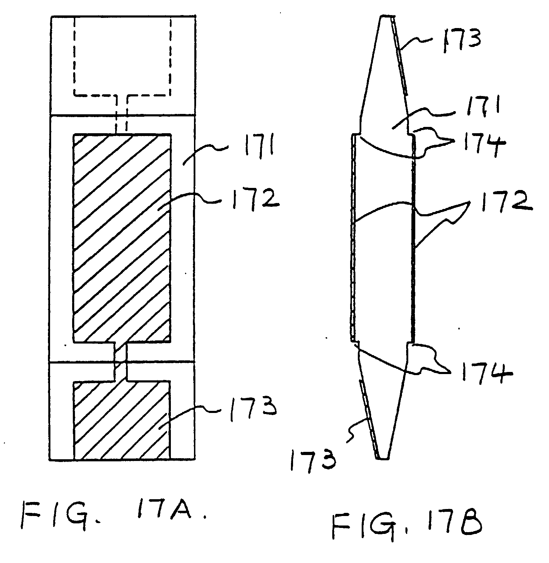

Figures 17A and 17B illustrate a thirteenth embodiment of an AT-cut crystal oscillating element or reed according to the present invention, Figure 17A being a plan view and Figure 17B being a side elevational view. Referring to Figures 17A and 17B, reference numeral 171 represents a crystal oscillating element, 172 represents excitation electrodes, 173 represents connection electrodes for establishing a connection with external equipment, and 174 represents steps. The AT-cut crystal oscillating element serves as an oscillator for oscillating at a relatively low frequency, the AT-cut crystal oscillating element therefore being subjected to bevel machining in its lengthwise directional end surface since the bevel machining is used when an oscillator of a type capable of confining energy is desired. The steps 174 are able to further effectively confine energy.

Although omitted from illustration, convex machining applied to the end surface will achieve a similar effect.

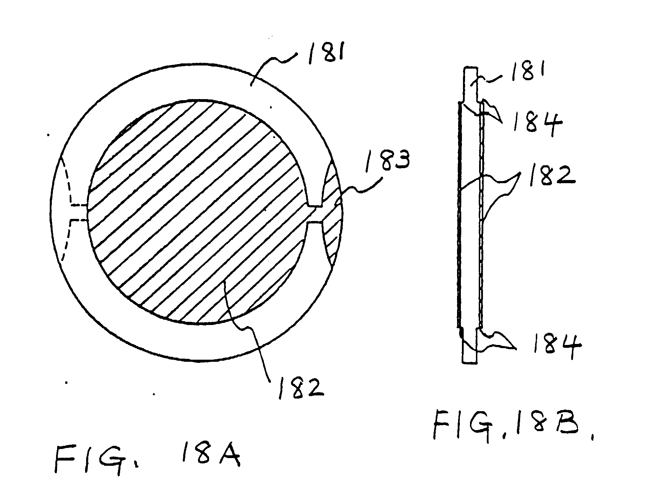

Figures 18A and 18B illustrate a fourteenth embodiment of an AT cut-crystal oscillating element according to the present invention, Figure 18A being a plan view and Figure 18B being a cross-sectional view of the central portion of the AT-cut crystal oscillating element. Referring to Figures 18A and 18B, reference numeral 181 represents a crystal oscillating element, 182 represents excitation electrodes, 183 represents connection electrodes for establishing a connection with external equipment, and 184 represents steps. Although the AT-cut crystal oscillating reed shown in Figures 18A and 18B is in the form of a disc, an effect of confining energy can be obtained similar to that of the above-described embodiments by virtue of the existence of the steps 184.

The present invention is not limited to the described position of the steps which are formed at the periphery of the excitation electrodes. The steps may be provided near to the periphery of the element or near to the centre thereof.

The present invention is particularly effective when a crystal oscillating element is manufactured by etching. That is, etching cannot be combined with convex machining applied to the end portion of the crystal oscillating element or to bevel machining which may be used to make the shape shown in Figure 17B, each of those processes having been performed for the purpose of improving characteristics such as the CI value. However, a rectangular AT cut-crystal oscillating element as shown in Figures 16A-16C has the advantage that physical properties such as the CI value can be improved without performing conventional machining such as convex machining. A plane which is substantially perpendicular to the main surface is used at the end surface.

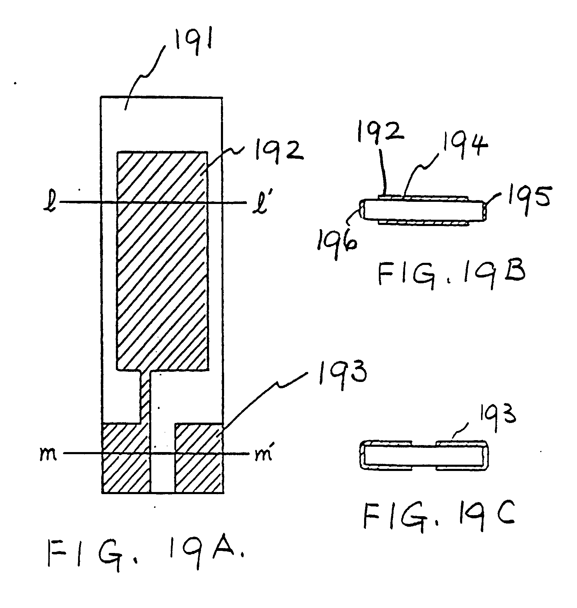

Figures 19A-19C illustrate a fifteenth embodiment of an AT-cut crystal oscillating element according to the present invention, Figure 19A being a plan view, Figure 19B being a cross-sectional view taken along line 1-1' of Figure 19A and Figure 19C being a cross-sectional view taken along line m-m' of Figure 19A. Referring to Figures 19A-19C, reference numeral 191 represents a crystal oscillating element, 192 represents excitation electrodes, 193 represents connection electrodes for establishing a connection with external equipment, 194 represents a main surface of the element, 195 represents side surfaces of the element and 196 represents side electrodes.

Each connection electrode 193 for establishing a connection with external equipment incorporates, as shown in Figure 19B, a side electrode 196 on the side surface for the purpose of electrically connecting the two opposite sides of the element in addition to having electrodes 192 formed on the main surfaces 194. The side electrodes 196 are thus electrically connected to the connection electrodes 193 for establishing a connection with external equipment. The side electrodes 196 are electrically separated from each other on the lower and the upper end surfaces of the crystal oscillating element 191.

A method of manufacturing an AT-cut crystal oscillating element according to the present invention will now be described, the method involving using photo-etching technology. Figures 20A-20L schematically illustrate a machining process.

Figures 20A and 20B respectively illustrate a crystal wafer which has been obtained by cutting a rough crystal and subsequently cutting it to a predetermined thickness. Figure 20A is a plan view and Figure 20B is a cross-sectional view. The crystal wafer usually has a size from which a plurality of crystal oscillating elements or reeds can be obtained simultaneously.

Figures 20C and 20D respectively illustrate a condition in which a metal film has been formed. Reference numeral 201 represents the crystal wafer and 202 represents the metal film. The metal film 202 is formed by a sputtering process in which chromium and gold is used.

Figures 20E and 20F respectively illustrate a condition in which the metal film 202 has been given a predetermined shape. Reference numeral 203 represents a photoresist film. The photoresist film 203 is applied to the crystal wafer 201 on which the metal film 202 has been formed. Then a photomask is used having a black and white pattern corresponding to the contours of the crystal oscillating elements to be formed and the photoresist is exposed to light. Then, the photoresist is developed and the metal film is subjected to etching, causing the condition shown in Figures 20E and 20F to be realized.

Figures 20G and 20H respectively illustrate a condition in which the crystal oscillating elements have been formed by etching the crystal wafer 201, while using the metal film 202, which has been subjected to etching to produce the shape of the crystal oscillating elements and to act as a corrosion resisting film.

Figures 20I and 20J illustrate a condition in which an electrode film has been formed. Referring to Figure 20J, reference numeral 204 represents an electrode film. The photoresist 203 is removed from the metal film 202 which has been given the shape of the crystal oscillating elements which have been formed, and the metal film is formed to serve as the electrode film 204.

The metal film is formed by sputtering or diagonally evaporating a pair of metals consisting of chromium and gold or a pair of metals consisting of chromium and silver.

Figures 20K and 20L respectively illustrate a condition in which the electrode film is given a predetermined shape. A photoresist film is applied to :he crystal wafer on which the electrode film has been formed. Then, a photomask is used having a white and black pattern corresponding to the shape of the electrodes and the photoresist is exposed to light. The photoresist is then developed, the metal film is subjected to etching and the photoresist is removed, causing the condition shown in Figures 20K and 20L to be realized. Since the photoresist material is diagonally sprayed onto the bottom of the crystal oscillating elements, the photoresist does not adhere to the upper end surfaces of the crystal oscillating elements. As a result, the electrode film formed on the upper end surfaces of the crystal oscillating elements is subjected to etching. In consequence, the electrode film is completely removed from the said upper end surfaces. On the other hand, the photoresist adheres to the two side surfaces and the lower surface of the crystal oscillating element and a portion of the photoresist which is not exposed to light is left even after the development. As a result, electrode film is left after it has been subjected to etching. The residual electrode film becomes the side electrodes 207. Reference numeral 205 represents crystal oscillating elements and 206 represents tie bars. When the crystal oscillating elements 205 are introduced into a package, the crystal oscillating elements 205 are removed from the tie bars 206. At this time, the side electrodes 206 disposed at the bottom of the crystal oscillating elements 205 are electrically disconnected from each other.

Figure 21 is a cross-sectional view which illustrates the excitation electrode portion of an embodiment of an AT-cut crystal oscillating element according to the present invention. Referring to Figure 21, reference numeral 211 represents a crystal oscillating element, 212 represents excitation electrodes and 213 represents side electrodes. Further referring to Figure 21, the arrows designate the direction of an electric field acting on the crystal oscillating element 211. Since other electric fields acting between the side electrodes 213 and the excitation electrodes 212 are also generated in addition to the electric field acting between the excitation electrodes 212, the CI value is improved. The electric fields acting between the side electrodes 213 and the excitation electrodes 212 do not increase spurious oscillation because these electric fields act not only in the direction of the thickness of the element but also in the widthwise direction thereof and therefore do not contribute to the spurious oscillation.

Figure 22 is a cross-sectional view which illustrates an excitation electrode portion of another embodiment of an AT-cut crystal oscillating element according to the present invention. Referring to Figure 22, reference numeral 221 represents a crystal oscillating element, 222 represents first excitation electrode films, 223 represents second excitation electrode films and 224 represents side electrodes.

The crystal oscillating element shown in Figure 22 is manufactured by a method which is different from the process shown in Figures 20I and 20J. In the latter, the crystal oscillating element shown in Figures 19A-19C is manufactured by newly adhering the metal for forming the electrode film after the photoresist and the metal film have been separated from one another. However, the crystal oscillating element shown in Figure 22 is manufactured by a method in which only the photoresist is removed and then the metal film is formed on the portion from which the photoresist has been removed. Therefore, the excitation electrode portion of the element comprises double layer structures each of which is composed of the respective first excitation electrode film 222 and the respective second excitation electrode film 223. Since the thickness of the metal films in the excitation electrode portion of the crystal oscillating element shown in Figure 22 can be enlarged, a significant effect in confining oscillation energy in the excitation electrode portion can be obtained.

A significant effect can also be obtained in the case of the present invention when a crystal oscillating element is formed by sequential etching operations. That is, the etching process cannot be combined with a conventional convex process or a bevel process to which the end portion of a crystal oscillating element is subjected in order to improve the characteristics such as the CI value. However, the CI value can be improved without using the convex process or the bevel process in the case of an AT-cut crystal oscillating element according to the present invention.

Figures 23A-23K schematically illustrate a process for making an AT-cut crystal oscillating element according to the present invention. Figure 23A illustrates a process of cutting a rough crystal into crystal wafers and Figures 23B and 23C illustrate a process of grinding a crystal wafer so produced. Figures 23D and 23E illustrate the formation of a metal film, Figures 23F and 23G illustrate the shaping of the metal film, Figures 23H and 23I illustrate the formation of the oscillating elements and Figures 23J and 23K illustrate the formation of the electrode films. Figures 23B, 23D, 23F, 23H and 23J are plan views and Figures 23C, 23E, 23G, 23I and 23K are cross-sectional views. Reference numeral 231 represents a rough crystal, 232 represents a crystal wafer produced from the rough crystal 231, 233 represents a metal film, 234 represents a crystal oscillating element and 235 represents electrode films.

The above-mentioned process will now be described in detail.

In the steps shown in Figures 23A, 23B and 23C, a rough crystal 231 is cut at a predetermined angle to obtain a crystal wafer 232, usually by using a so-called "boundary" in the crystal. Subsequently, the crystal wafer is ground to give it a predetermined thickness.

In the step shown in Figures 23D and 23E for forming the metal film 233, the metal film 233 is formed on the crystal wafer 232 by evaporation or sputtering. Chromium is used as a base and gold or silver is subsequently used.

In the step shown in Figures 23F and 23G for shaping the metal film, photographic technology is used. First, a photoresist is applied to the surface of the crystal wafer 232 on which the metal film 233 has been formed. Subsequently, a photomask, which forms the shape of the crystal oscillating elements by its white and black pattern, and the photoresist is exposed to light. The photoresist is then developed, and the residual photoresist is arranged to form the corrosion resisting film before the metal film is removed.

In the step shown in Figures 23H and 23I for shaping the crystal oscillating member, crystal in the exposed portion is removed by etching while the metal film 233 formed in the step of Figures 23F and 23G is arranged to serve as the corrosion resisting film. As the etching liquid, a solution comprising a mixture of hydrofluoric acid and ammonium fluoride is used.

In the step shown in Figures 23J and 23K for forming the shape of the electrode film, the electrode film 235 for applying the electric field to the crystal oscillating element 234 is formed by utilizing photographic technology which is similar to that employed in the step shown in Figures 23F and 23G for forming the shape of the metal film. Simultaneously, connection electrodes to establish a connection with an external terminal is formed.

A multiplicity of the crystal oscillating elements 234 may be simultaneously formed in one crystal wafer. The crystal oscillating elements 234 are connected to portions of the crystal wafer by so-called "tie bars" 236, and they are respectively connected to the same wafer after they have been formed as the crystal oscillating elements 234. When a crystal oscillating element 234 is to be connected to an external terminal, its portion connected to the tie bar 236 is broken so that it can be used as an independent crystal oscillating element.

As described with reference to Figures 20A-20L, it is arranged that the metal film 202 serving as the corrosion resisting film is removed and another metal film is newly formed as the electrode film by sputtering technology or the like. However, in this embodiment, the metal film used as the corrosion resisting film is not removed, but it is used as the electrode film by photo-etching. In consequence, the manufacturing process can be simplified.

The present invention comprises, inter alia, a method of manufacturing an AT-cut crystal oscillating element in which the metal film is in the form of a double-layer structure. That is, the first metal film used as the corrosion resisting film is left, the second metal film is formed by sputtering or the like, and it is formed as the electrode film by photoetching.

The method of shaping the crystal oscillating element may comprise the electrode film being completed by photoetching. In consequence, a plurality of AT-cut crystal oscillating elements can accurately and uniformly be obtained from a single crystal wafer.

The above-described method of etching a crystal oscillating element according to the present invention is carried out as follows when an AT-cut crystal wafer is subjected to etching. Assuming that the lengthwise component of the distance from the upper end to the lower end of the element on the side on which an extension connecting the upper end to the lower end of the corrosion resisting film substantially becomes the Z-axis parallel to the Z'-axis is 1, it is arranged that 1 is given the value t/tan θ° which is a lengthwise component, which is parallel to the Z'-axis, of the distance from an intersection of the Z-axis on the upper surface of the wafer to an intersection on the lower surface of the same. Furthermore, the value 1 is given to the distance between the upper ends and to the distance between the lower ends. In consequence, a crystal oscillating element having a side surface which is substantially perpendicular to the surface of the corrosion resisting film and having no step therein can be obtained. The thus constituted AT-cut crystal oscillating element according to the present invention is arranged so that a surface of the AT-cut crystal wafer which is to be subjected to etching is substantially perpendicular to a main surface of the wafer and the former surface is used as the end surface of the oscillating element. Therefore, a crystal oscillating element having a side surface which is substantially perpendicular to the surface of the corrosion resisting film and having no step can be obtained. As a result, an AT-cut crystal oscillating element can be obtained in which no spurious oscillation is generated, and which has excellent oscillation characteristics and no sharp step at its front portion which enables cracks to be prevented at the time of parts assembly and has a satisfactory impact resistance.

Furthermore, the main oscillating portion and the mount portion of the oscillator may have different widths. Therefore, the confining of oscillation energy can be improved so that an AT-cut crystal oscillating element having an excellent CI value can be obtained.

Furthermore, if the oscillators are arranged to oscillate at different frequencies, mount portions having a common widthwise dimension can be used. In consequence, common manufacturing jigs can be used. Therefore, a rectangular AT-cut crystal oscillating element can be provided which is suitable to be manufactured in a small quantity or in a multiplicity of types.

Furthermore, an AT-cut crystal oscillating element can be provided which can be manufactured by a reduced number of process steps thanks to the above-described etching and which therefore has a reduced cost and an excellent CI value.

A rectangular AT-cut crystal oscillator comprising an element according to the present invention may be arranged so that its end shape in the lengthwise direction is in the form of a parallelogram. In consequence, the effect of confirning the energy of the oscillating element can be improved so that a crystal oscillator can be provided having a low CI value.

Furthermore, an AT cut-crystal oscillating element can be manufactured from a reduced number of process steps thanks to the above-described etching so that it has a reduced cost and an excellent CI value.

An AT-cut crystal oscillator element according to the present invention may be arranged to have first and second metal films serving as excitation electrodes and may have both a portion in which the first and second metal films are stacked on one another and a portion in which only the first metal film or the second metal film is present. Therefore, the overlap effect of the excitation electrode can be improved, causing energy confining to be performed effectively. In consequence, an AT-cut crystal oscillator can be provided having a reduced CI value.

Furthermore, the AT-cut crystal oscillating element manufactured by the above-described etching has the advantage that its CI value can be improved without the necessity of machining. Therefore, improved AT-cut crystal oscillating elements can be obtained having uniform characteristics.

An AT-cut crystal oscillating element according to the present invention may be arranged to have a step at a boundary between the excitation electrode portion thereof and the other portion so that the thickness of the other portion is reduced. Therefore, an AT-cut crystal oscillating element having a significant energy confining effect and having a low CI value can be provided. In particular, a significant effect can be obtained when the size is reduced, enabling a small AT-cut crystal oscillator having an excellent performance to be provided.

Furthermore, the CI value of an AT-cut crystal oscillating element manufactured by the above-described etching can be improved without the necessity of performing machining. Therefore, improved AT-cut crystal oscillating elements having uniform characteristics can be obtained.

An electrode may be formed in the side portion of the main electrode portion. Therefore, the CI value can be improved while preventing spurious oscillations. In addition, since photo-etching can be employed, the manufacturing accuracy can be improved significantly. Therefore, uniform AT-cut crystal oscillating elements can be provided.

The shape of the crystal oscillating element may be formed by a process in which the shape of the electrode film is completed by photo-etching. In consequence, AT-cut crystal oscillating elements having uniform characteristics and significant reliability can be provided. In addition, the AT-cut crystal oscillating elements can be processed in the crystal wafer state enabling them to be mass produced.

## Claims

1. An AT-cut crystal oscillating element (1; 51) produced by forming spaced apart upper and lower corrosion resistant films (5,6; 52,53) on its upper and lower surfaces (1a, 1b) respectively, and etching the element, the upper and lower surfaces (1a, 1b) being parallel to a cutting axis Z', where the cutting axis Z' is defined relative to the Z-axis of the crystal by rotation around the X-axis by an angle θ, and characterised in that:
the films (5,6; 52,53) are spaced such that the distance (1';1") between the spaced apart films on each of the surfaces is at least t/tan θ, where t is the thickness of the element;
the distance (1) along the Z'-axis between diagonally opposing films (5,6; 52,53) is at least t/tan θ; and
the oscillating element has at least one end surface (1c, 1d) approximately perpendicular to the upper and lower surfaces (1a, 1b).

2. An AT-cut crystal oscillating element as claimed in claim 1, characterised in that θ is in the range from + 35° to + 40°.

3. An AT-cut crystal oscillating element as claimed in any preceding claim characterised in that the element has a mount portion (65) the width of which is different from the width of a main oscillating portion (64) thereof.

4. An AT-cut crystal oscillating element as claimed in any preceding claim characterised in that the element (101) is substantially rectangular in widthwise cross-section centrally of the element (101) and has an end surface (105) which is shaped substantially as a parallelogram.

5. An AT-cut crystal oscillating element as claimed in any preceding claim characterised in that the element (131) is provided on each of its opposite sides with first and second metal films which only partially overlap one another so that the cross-sectional shape of the element varies.

6. An AT-cut crystal oscillating element as claimed in any preceding claim characterised in that the element has at least one reduced thickness portion which meets another portion of the element at a step.

7. An AT-cut crystal oscillating element as claimed in any preceding claim characterised in that the element (191) has a main surface (194) on which there is at least one excitation electrode (192) for oscillating the element and at least one connection electrode (193) for establishing a connection with external equipment, a side electrode (196) being formed on at least one side surface of the element.

8. A method of making an AT-cut crystal oscillating element (1;51) comprising; forming spaced apart upper corrosion resistant films (5;52) on the upper surface (1a) of the element and spaced apart lower corrosion resistant films (6;53) on the lower surface (1b) of the element, the upper and lower surfaces being parallel to a cutting axis Z', where the cutting axis Z' is defined relative to the Z-axis of the crystal by rotation around the X-axis by an angle θ, and etching the element, characterised by spacing the films (5, 6;52,53) such that:
the distance (1';1") between the spaced-apart films on each of the surfaces is at least t/tan θ, where t is the thickness of the element; and
the distance (1) along the Z'-axis between diagonally opposing films (5,6; 52,53) is at least t/tan θ.

9. A method as claimed in claim 8, characterised by: the spaced-apart upper corrosion resistant films (5) being aligned with the spaced-apart lower corrosion resistant films (6) and the distance (1',1") between the spaced-apart films on each of the surfaces being equal to the distance (1) along the Z'-axis between the diagonally opposing films (5, 6).

10. A method as claimed in claim 8 characterised by: the spaced-apart upper corrosion resistant films (52) not being aligned with the spaced-apart lower corrosion resistant films (53) and the distance (1',1") between the spaced-apart films on each of the surfaces being greater than the distance (1) along the Z'-axis between the diagonally opposing films (52, 53).

11. A method as claimed in any one of claims 8 to 10 characterised by:
utilising metal films to serve as corrosion resistant films (5,6; 52,53) during etching of the AT-cut crystal oscillating element; and
etching the metal films so as to make them serve as electrode films.

12. A method claimed in any of claims 8 to 11, characterised in that θ is in the range from +35° to +40°.

## Patentansprüche

1. AT-geschnittenes Kristalloszillationselement (1; 51), hergestellt durch Bildung voneinander beabstandeter oberer und unterer korrosionsbeständiger Filme (5, 6; 52, 53) auf seiner oberen bwz. seiner unteren Oberfläche (1a, 1b), und Ätzen des Elements, wobei die obere und die untere Oberfläche (1a, 1b) zu einer Schneidachse Z' parallel sind, wobei die Schneidachse Z' relativ zur Z-Achse des Kristalls durch Rotation um die X-Achse um einen Winkel θ definiert ist, und gekennzeichnet dadurch, daß:
die Filme (5, 6; 52, 53) derart beabstandet sind, daß der Abstand (1', 1") zwischen den beabstandeten Filmen auf jeder der Oberflächen mindestens t/tan θ beträgt, wobei t die Dicke des Elemtents ist;
der Abstand (1) entlang der Z'-Achse zwischen diagonal gegenüberliegenden Filmen (5, 6; 52, 53) mindestens t/tan θ beträgt; und
das Oszillationselement mindestens eine Endoberfläche (1c, 1d) in etwa senkrecht zur oberen und unteren Oberfläche (1a, 1b) aufweist.

2. AT-geschnittenes Kristalloszillationselement gemäß Anspruch 1, dadurch gekennzeichnet, daß θ im Bereich von +35° bis +40° liegt.

3. AT-geschnittenes Kristalloszillationselement gemäß einem der vorhergehenden Ansprüche, dadurch gekennzeichnet, daß das Element einen Montierbereich (65) aufweist, dessen Breite sich von der Breite eines Hauptoszillationsteils (64) hiervon unterscheidet.

4. AT-geschnittenes Kristalloszillationselement gemäß einem der vorhergehenden Ansprüche, dadurch gekennzeichnet, daß das Element (101) im wesentlichen rechtwinklig im breitenweisen Querschnitt zentral des Elements (101) ist und eine Endoberfläche (105) aufweist, welche im wesentlichen als Parallelogramm geformt ist.

5. AT-geschnittenes Kristalloszillationselement gemäß einem der vorhergehenden Ansprüche, dadurch gekennzeichnet, daß das Element (131) auf jeder seiner gegenüberliegenden Seiten mit ersten und zweiten Metallfilmen versehen ist, welche sich nur teilweise überlappen, so daß die Querschnittsform des Elements variiert.

6. AT-geschnittenes Kristalloszillationselement gemäß einem der vorhergehenden Ansprüche, dadurch gekennzeichnet, daß das Element mindestens einen reduzierten Dickenbereich aufweist, welcher einen anderen Bereich des Elements an einer Stufe trifft.

7. AT-geschnittenes Kristalloszillationselement gemäß einem der vorhergehenden Ansprüche, dadurch gekennzeichnet, daß das Element (191) eine Hauptoberfläche (194) aufweist, worauf sich mindestens eine Erregerelektrode (192) zur Oszillation des Elements befindet, sowie mindestens eine Verbindungselektrode (193) zur Schaffung einer Verbindung mit einer äußeren Vorrichtung, wobei eine Seitenelektrode (196) auf mindestens einer Seitenoberfläche des Elements gebildet ist.

8. Verfahren zur Herstellung eines AT-geschnittenen Kristalloszillationselements (1; 51), umfassend: Bildung voneinander beabstandeter oberer korrosionsbeständiger Filme (5; 52) auf der oberen Oberfläche (1a) des Elements und voneinander beabstandeter unterer korrosionsbeständiger Filme (6; 53) auf der unteren Oberfläche (1b) des Elements, wobei die obere und die untere Oberfläche zu einer Schneidachse Z' parallel sind, wobei die Schneidachse Z' relativ zur Z-Achse des Kristalls durch Rotation um die X-Achse um einen Winkel θ definiert ist, und Ätzen des Elements, dadurch gekennzeichnet, daß die Filme (5, 6; 52, 53) derart beabstandet werden, daß:
der Abstand (1', 1") zwischen den beabstandeten Filmen auf jeder der Oberflächen mindestens t/tan θ beträgt, wobei t die Dicke des Elemtents ist; und
der Abstand (1) entlang der Z'-Achse zwischen diagonal gegenüberliegenden Filmen (5, 6; 52, 53) mindestens t/tan θ beträgt.

9. Verfahren gemäß Anspruch 8, dadurch gekennzeichnet, daß: die beabstandeten oberen korrosionsbeständigen Filme (5) mit den beabstandeten unteren korrosionsbeständigen Filmen (6) ausgerichtet werden und der Abstand (1', 1") zwischen den beabstandeten Filmen auf jeder der Oberflächen dem Abstand (1) entlang der Z'-Achse zwischen den diagonal gegenüberliegenden Filmen (5, 6) entspricht.

10. Verfahren gemäß Anspruch 8, dadurch gekennzeichnet, daß: die beabstandeten oberen korrosionsbeständigen Filme (52) mit den beabstandeten unteren korrosionsbeständigen Filmen (53) ausgerichtet sind und der Abstand (1', 1") zwischen den beabstandeten Filmen auf jeder der Oberflächen größer als der Abstand (1) entlang der Z'-Achse zwischen den diagonal gegenüberliegenden Filmen (52, 53) ist.

11. Verfahren gemäß einem der Ansprüche 8 bis 10, gekennzeichnet durch:
Verwendung von Metallfilmen, um als korrosionsbeständige Filme (5, 6; 52, 53) zu dienen, während das AT-geschnittene Kristalloszillationselement geätzt wird, und
Ätzung der Metallfilme, damit diese als Elektrodenfilme dienen.

12. Verfahren gemäß einem der Ansprüche 8 bis 11, dadurch gekennzeichnet, daß θ im Bereich von +35° bis +40° liegt.

## Revendications

1. Elément oscillant (1 ; 51) à cristal à taille AT, produit par formation de films supérieur et inférieur distants (5, 6 ; 52, 53) résistant à la corrosion sur ses faces supérieure et inférieure (1a, 1b) respectivement, et par gravure de l'élément, les surfaces supérieure et inférieure (1a, 1b) étant parallèles à un axe de coupe Z', l'axe de coupe Z' étant délimité par rapport à un axe Z du cristal par rotation autour de l'axe X d'un angle θ, caractérisé en ce que
les films (5, 6 ; 52, 53) sont espacés afin que la distance (1' ; 1") comprise entre les films distants sur chacune des surfaces soit au moins égale à t/tgθ, t étant l'épaisseur de l'élément,
la distance (l) le long de l'axe Z' entre les films opposés en diagonale (5, 6 ; 52, 53) est au moins égale à t/tgθ, et
l'élément oscillant a au moins une surface d'extrémité (1c, 1d) approximativement perpendiculaire aux surfaces supérieure et inférieure (1a, 1b).

2. Elément oscillant à cristal à taille AT selon la revendication 1, caractérisé en ce que θ est compris entre +35° et +40°.

3. Elément oscillant à cristal à taille AT selon l'une quelconque des revendications précédentes, caractérisé en ce que l'élément a une partie de montage (65) dont la largeur est différente de celle de la partie principale d'oscillation (64).

4. Elément oscillant à cristal à taille AT selon l'une quelconque des revendications précédentes, caractérisé en ce que l'élément (101) est pratiquement rectangulaire en coupe suivant la largeur au centre de l'élément (101) et possède une surface d'extrémité (105) ayant pratiquement la forme d'un parallélogramme.

5. Elément oscillant à cristal à taille AT selon l'une quelconque des revendications précédentes, caractérisé en ce que l'élément (131) comporte, sur chacune de ses faces opposées, un premier et un second film métallique qui ne se recouvrent que partiellement si bien que la configuration en coupe de l'élément varie.

6. Elément oscillant à cristal à taille AT selon l'une quelconque des revendications précédentes, caractérisé en ce que l'élément a au moins une partie d'épaisseur réduite qui rejoint une autre partie de l'élément par un gradin.

7. Elément oscillant à cristal à taille AT selon l'une quelconque des revendications précédentes, caractérisé en ce que l'élément (191) a une surface principale (194) sur laquelle est placée au moins une électrode d'excitation (192) destinée à provoquer l'oscillation de l'élément et au moins une électrode de connexion (193) destinée à établir une connexion avec un appareillage externe, et une électrode latérale (196) étant formée sur au moins une surface latérale de l'élément.

8. Procédé de fabrication d'un élément oscillant (1 ; 51) à cristal à taille AT, comprenant :
la formation de films supérieurs distants (5 ; 52) résistant à la corrosion à la surface supérieure (la) de l'élément et de films inférieurs distants (6 ; 53) résistant à la corrosion à la surface inférieure (1b) de l'élément, les surfaces supérieure et inférieure étant parallèles à un axe de taille Z', l'axe de taille Z' étant défini par rapport à l'axe Z du cristal par rotation autour de l'axe X d'un angle θ, et la gravure de l'élément, caractérisé par un espacement des films (5, 6 ; 52, 53) tel que :
la distance (l' ; l") comprise entre les films distants sur chacune des surfaces est au moins égale à t/tgθ, t étant l'épaisseur de l'élément, et
la distance (l) le long de l'axe Z' entre les films opposés en diagonale (5, 6 ; 52, 53) est au moins égale à t/tgθ.

9. Procédé selon la revendication 8, caractérisé en ce que les films supérieurs distants (5) résistant à la corrosion sont alignés sur les films inférieurs distants (6) résistant à la corrosion, et la distance (l', l") comprise entre les films distants sur chacune des surfaces est égale à la distance (l) le long de l'axe (Z') entre les films opposés en diagonale (5, 6).

10. Procédé selon la revendication 8, caractérisé en ce que les films supérieurs distants (52) résistant à la corrosion ne sont pas alignés sur les films inférieurs distants (53) résistant à la corrosion, et la distance (l', l") comprise entre les films distants sur chacune des surfaces est supérieure à la distance (l) le long de l'axe Z' entre les films opposés en diagonale (52, 53).

11. Procédé selon l'une quelconque des revendications 8 à 10, caractérisé par :
l'utilisation de films métalliques comme films résistant à la corrosion (5, 6 ; 52, 53) pendant la gravure de l'élément oscillant à cristal à taille AT, et
la gravure des films métalliques afin qu'ils puissent être utilisés comme films d'électrode.

12. Procédé selon l'une quelconque des revendications 8 à 11, caractérisé en ce que θ est compris entre +35° et +40°.
